**Europäisches Patentamt**

**European Patent Office**

**Office européen des brevets**

(19)

(11) Veröffentlichungsnummer: **0 045 862**

**A1**

(12) # EUROPÄISCHE PATENTANMELDUNG

(21) Anmeldenummer: **81105620.9**

(22) Anmeldetag: **17.07.81**

(51) Int. Cl.³: **H 01 S 3/23**

(30) Priorität: **07.08.80 US 176166**

(43) Veröffentlichungstag der Anmeldung:
**17.02.82** Patentblatt **82/7**

(84) Benannte Vertragsstaaten:
**DE FR GB NL**

(71) Anmelder: **Hewlett-Packard Company**
**1501 Page Mill Road**
**Palo Alto California 94304(US)**

(72) Erfinder: **Ackley, Donald Elton**
**1041 Junipero Avenue**
**Redwood City, California(US)**

(72) Erfinder: **Engelmann, Reinhart Wolfgang Hanns**
**2423 Benjamin Drive**
**Mountain View California 94043(US)**

(72) Erfinder: **Kerps, Dietrich**
**3560 Whitsell Avenue**
**Palo Alto California 94306(US)**

(74) Vertreter: **Luberichs, Albert, Dipl.-Ing.**
**c/o Hewlett-Packard GmbH Herrenberger Strasse 110**
**D-7030 Böblingen(DE)**

(54) Halbleiterlaser.

(57) Ein Halbleiterlaser weist eine Vielzahl von Streifenbereichen (100,102) auf, die durch optische Streuung miteinander gekoppelt sind.

FIG I

EP 0 045 862 A1

Hewlett-Packard Company


H A L B L E I T E R L A S E R


Halbleiterlaser sind bekannte Vorrichtungen, bei denen die Injektion von Ladungsträgern durch eine oder mehrere Halbleiterübergänge zu einer stimmulierten Emission von Strahlung führt. An der Vorrichtung sind verspiegelte Facetten vorgesehen, die einen Hohlraum einschließen, in welchem die stimulierte Emission einen Laserbetrieb in einer aktiven Schicht erzeugt, wenn die injizierte Stromdichte oberhalb eines bestimmten Schwellwertes liegt. Ein Betrieb solcher Vorrichtungen mit hoher Ausgangsleistung ist beschränkt durch die Empfindlichkeit der Spiegelfacetten für Beschädigungen, wenn sie mit zu hoher Intensität beleuchtet werden.

Bekannte Hochleistungs-Halbleiterlaser haben im allgemeinen breite Emissionsbereiche, um das optische Feld zu streuen. Dadurch wird die auf die Spiegelfacetten auftreffende Intensität reduziert und eine Zerstörung verhütet. Jedoch haben solche Vorrichtungen den Nachteil, daß die Kontrolle über Seitenschwingungen in der Übergangsebene nicht gegeben ist. Dies kann zu fadenförmiger Veränderung und Selbstfokussierung der Strahlung führen, wodurch unbefriedigende Veränderungen im Intensitätsverteilungsmuster des Fernfeldes entstehen. Ein weiteres nachteiliges Ergebnis von unkontrollierten Seitenschwingungsarten sind Nichtlinearitäten oder "Knicke" in der Beziehung zwischen Strom und Ausgangslicht.

Es sind Hochleistungslaser bekannt, bei denen ein Feld von schmalen Streifen den Leitungsträgerfluß seitlich begrenzt. Streifenbreiten von ungefähr 3 bis 5 μm hemmen ungewollte

**0045862**

Hewlett-Packard Comp.
Int. Az.: Case 1453

Seitenschwingungsarten, und die Vorrichtung arbeitet als ein Feld von vielen Lasern niedriger Leistung. Durch dichte Packung der Streifen mit Mittelabständen von 8 bis 15 μm läßt sich eine gewisse Interaktion der optischen Schwundfelder von benachbarten Streifen erreichen. Beispiele solcher Vorrichtungen sind beschrieben in "Applied Physics Letters", Band 33, No. 12, Dezember 1978 und Band 34, No. 2, Januar 1979. Solche Vorrichtungen haben jedoch den Nachteil, daß die einzelnen Laserbereiche bei Injektion eines Stromimpulses nicht gleichzeitig mit dem Laserbetrieb beginnen ("einschalten"). Dies kann während der Einschaltperiode zu einem instabilen Fernfeldmuster führen. Ein anderer Nachteil ist, daß die Kopplung zwischen den einzelnen Laserregionen bei hohen Ansteuerströmen zur Abschwächung neigt.

Bei einer Abwandlung des dicht gepackten Streifenfeldes werden gebogene Kontaktleiter benutzt, die die Streifen im Feld verbinden ("Applied Physics Letters", Band 34, No. 4, Februar 1979). Dadurch wird die Kopplung zwischen den Streifen verbessert, wodurch die Schwere der oben genannten Nachteile vermieden wird. Solche Vorrichtungen haben aber immer noch den Nachteil des nicht gleichzeitigen Einschaltens und des Kopplungsverlustes bei hohen Ansteuerströmen.

Der Erfindung gemäß Anspruch 1 liegt die Aufgabe zugrunde, einen Halbleiterlaser mit einem Streifenfeld zu schaffen, der ein gleichzeitiges Einschalten ermöglicht und bei dem kein Kopplungsverlust bei höheren Ansteuerströmen auftritt.

Gemäß einer bevorzugten Ausführungsform der Erfindung enthält der Halbleiterlaser mehrere aktive Streifenbereiche, die durch passive Bereiche voneinander getrennt sind. Der Brechungsindex der passiven Bereiche ist so gewählt, daß der Laser, der die optische Kopplung zwischen benachbarten Streifenbereichen herstellt, im Streubetrieb arbeiten kann. Eine optische Kopplung mit Streubetrieb sorgt für ein nahezu gleichzeitiges Einschalten der Streifen und ermöglicht den Aufbau eines einfachen Fernfeldmusters, das bei hohen Ansteuerströmen stabil ist. Bei einem besonders bevorzugten Ausführungsbeispiel ist der Brechungsindex-Sprung an den seitlichen Grenzen der Streifenbereiche positiv, so daß der für den Laserbetrieb erforderliche Schwellwert der Stromdichte verringert wird.

Weitere vorteilhafte Ausführungsformen bzw. Weiterbildungen der Erfindung sind in den Unteransprüchen gekennzeichnet.

Die Erfindung wird im folgenden anhand von Ausführungsbeispielen in Verbindung mit der zugehörigen Zeichnung erläutert. In der Zeichnung zeigen:

Fig. 1 einen Teil eines Halbleiterlasers mit einer Vielzahl von durch Streuung gekoppelten Streifenbereichen und

Fig. 2 eine Endansicht eines Teils eines anderen Halbleiterlasers mit einer Vielzahl von durch Streuung gekoppelten Streifenbereichen.

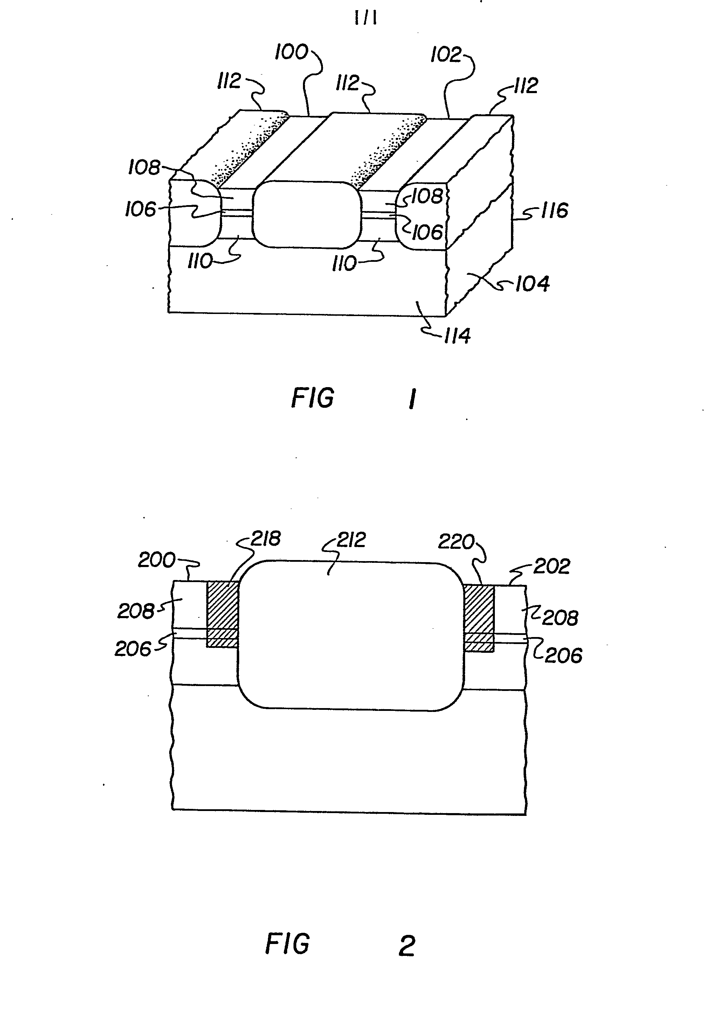

In Figur 1 ist ein Halbleiterlaser dargestellt, der ein Paar von Streifenbereichen 100 und 102 aufweist, die auf einem Substrat 104 liegen. Jeder Streifenbereich enthält eine aktive Schicht 106, die zwischen einem Paar von Deckschichten 108 und 110 eingeschlossen sind. Drei passive Bereiche 112 liegen auf dem Substrat an den seitlichen Grenzen der Streifenbereiche. Facetten 114 und 116 sind durch Abschneiden hergestellt und dienen als Spiegel.

Bei einem bevorzugten Ausführungsbeispiel besteht das Substrat aus GaAs des n-Typs. Die Streifenbereiche 100 und 102 werden vorzugsweise durch dreischichtiges epitaxiales Wachsen in der flüssigen Phase hergestellt, welchem eine Ätzung folgt, so daß Streifenbereiche von etwa 2 μm Breite mit einem Mittelabstand von etwa 24 μm verbleiben. Für die aktive Schicht, die vorzugsweise aus $Al_{0,06}Ga_{0,94}As$ des p-Typs besteht, wird eine Dicke von

Hewlett-Packard Comp.

Int. Az.: Case 1453

etwa 0,15 µm bevorzugt. Die Deckschicht 108 besteht vorzugsweise aus $Al_{0,3}Ga_{0,7}As$ des p-Typs, während die Deckschicht 110 aus $Al_{0,3}Ga_{0,7}As$ des n-Typs besteht. Nach dem Ätzen der Streifenbereiche erfolgt eine zweite epitaxiale Züchtung, wodurch die passiven Bereiche 112 gebildet werden, und zwar vorzugsweise aus undotiertem Material hohen Widerstandes wie $Al_{0,7}Ga_{0,83}As$. Aus Gründen der Klarheit und Vereinfachung der Beschreibung sind in Figur 1 nur zwei Streifenbereiche dargestellt. Es ist jedoch klar, daß sich die gleichen Konstruktions- und Betriebsprinzipien auf mehr als zwei Streifen ausdehnen lassen.

Bei der oben beschriebenen Ausführungsform beträgt der Brechungsindex der Deckschichten 108 und 110 etwa 3,42, während die aktive Schicht 106 einen Brechungsindex von ungefähr 3,625 hat. Da die aktive Schicht verglichen mit der Breite der Streifenbereiche dünn ist, lassen sich bekanntlich die Streifenbereiche durch einen effektiven Brechungsindex $n_{eff}$ beschreiben. Eine Erläuterung dazu findet sich zum Beispiel in "IEEE Journal of Quantum Electronics, Band QE-16, Nr. 2, Februar 1980, Seite 206. Beim bevorzugten Ausführungsbeispiel ist $n_{eff}$ etwa 3,475. Die passiven Bereiche 112 haben einen Brechungsindex $n_p$ von vorzugsweise etwa 3,525, so daß $n_p$ den Brechungsindex $n_{eff}$ um einen Betrag $\Delta n$ von etwa 0,05 übersteigt, so daß an den seitlichen Grenzen der Streifenbereiche ein Brechungsindex-Sprung entsteht. Im Betrieb werden Ladungsträger in den Laser injiziert, so daß in der aktiven Schicht jedes Streifenbereichs ein Laserbetrieb angeregt wird. Der Brechungsindex-Sprung an den Grenzen der Streifenbereiche führt zur Brechung von Licht aus dem Streifenbereich heraus in die angrenzenden passiven Bereiche. Jeder Streifenbereich arbeitet somit im sogenannten "Leck"- oder Streubetrieb, bei dem Strahlung in die passiven Bereiche gestreut wird. Die sich dadurch zwischen den Streifenbereichen ausbreitende Leistung führt zu einer Verdünnung der auf die Facetten fallenden Intensität und zu einer optischen Kopplung

Hewlett-Packard Comp.
Int. Az.: Case 1453

zwischen den Streifenbereichen, wobei die passiven Bereiche als passive Wellenleiter mit niedrigem Verlust arbeiten.

Die Strahlung streut aus den Streifenbereichen in die passiven Bereiche unter einem kleinen Winkel θ, für den gilt:

$$\sin \theta = (n_p^2 - n_{eff}^2)^{1/2}/n_p.$$

Für $\Delta n = 0,05$, das zur Sicherstellung des Streubetriebes mit annehmbarem Schwellwert für die Stromdichte ausgewählt wurde, beträgt der Winkel θ etwa 9,7°. Die Streustrahlung führt zu einer optischen Kopplung zwischen den Streifenbereichen durch Anregung von Schwingungsarten höherer Ordnung im passiven Bereich. Der Laserbetrieb zwischen den Streifenbereichen ist effektiv die Betriebsart, bei der der Fortpflanzungswinkel am stärksten dem Winkel angepaßt ist, bei welchem Strahlung aus den Streifenbereichen herausgestreut wird. Eine optische Kopplung zwischen den Streifenbereichen wird weiterhin dadurch verstärkt, daß die Streuwellenfronten mit den Feldern in den Streifenbereichen zusammenwirken, wodurch die relative Phase in den Streifenbereichen beeinflußt wird und eine feste Phasenverschiebung eingeführt wird. Im Intensitätsverteilungsmuster des Fernfeldes bewirkt die Phasendifferenz ein dicht beabstandendes Keulenmuster, das um die Facettennormale zentriert ist. In Ausführungsformen mit mehr als zwei Streifenbereichen ist dieses benachbarte Paar von Streifenbereichen durch Streustrahlen in einem passiven Bereich zwischen dem Paar optisch gekoppelt.

Die in Figur 2 dargestellte weitere Ausführungsform der Erfindung weist einen positiven Brechungsindex-Sprung an den seitlichen Grenzen eines Paars von Streifenbereichen 200 und 202 auf. Zonen 218 und 220 längs der Grenzen haben einen Brechungsindex, der um etwa 0,01 größer als der effektive Brechungsindex der Streifenbereiche, jedoch kleiner als der Brechungsindex eines passiven Bereichs 212 ist. Dieser Brechungsindex-Sprung läßt sich durch Diffusion einer p-Dotierung, z.B. Zink, durch die Deckschichten 208 und die aktive Schicht 206 des n-Typs herbeiführen. Diese

Hewlett-Packard Comp.
Int. Az.: Case 1453

Ausführungsform hat den Vorteil, daß ein wesentlich niedrigerer Schwellwert für die Stromdichte vorhanden ist als bei der Ausführungsform gemäß Fig. 1. Trotzdem läßt sich die Ausführungsform gemäß Fig. 2 leicht mit mehr als zwei Streifenbereichen aufbauen und betreiben.

Die oben beschriebenen Ausführungsformen haben alle eine dreischichtige Struktur in den Streifenbereichen zum vertikalen Einschließen der Strahlung. Andere Strukturen mit vertikalem Einschluß, zum Beispiel Strukturen mit großem opitschen Hohlraum können auch benutzt werden, vorausgesetzt, daß die Brechungsindizes der Materialien so gewählt sind, daß ein Streubetrieb möglich ist.

In allen diesen Ausführungsformen ermöglicht die Intensitätsverdünnung an den Facetten infolge der Streuung einen Betrieb bei hohen optischen Leistungspegeln ohne Zerstörung der Facetten. Außerdem sorgt die geringe Breite der aktiven Schicht der Vorrichtung für eine gute Kontrolle der Seitenschwingungsarten, was zu stabilen Fernfeldern und einernahezu linearen Ausgangscharakteristik führt. Ein weiteres vorteilhaftes Ergebnis ist das nahezu gleichzeitige Einschalten über den gesamten Laserbereich infolge der optischen Streukopplung zwischen den Streifenbereichen. Die Streukopplung führt auch zu einem einfachen Fernfeldmuster, das bis zu hohen Ansteuerströmen stabil ist. Ein weiterer Vorteil besteht darin, daß relativ große Abstände zwischen den Streifenbereichen vorhanden sein können, ohne daß eine gute Kopplung beeinträchtigt wird.

Hewlett-Packard Company

Int. Az.: Case 1453

13. Juli 1981

P a t e n t a n s p r ü c h e

1. Halbleiterlaser mit einem Substrat (104) aus Halbleitermaterial, einer Vielzahl von Streifenbereichen (100, 102, 200, 202) auf dem Substrat, in welchem durch Injektion von Ladungsträgern ein Laserbetrieb anregbar ist, sowie einem Paar von Spiegelfacetten (114, 116) an entgegengesetzten Enden des Substrats, dadurch  g e k e n n z e i c h - n e t ,  daß jeder Streifenbereich eine aktive Schicht (106, 206) aufweist und daß die Streifenbereiche seitlich durch passive Bereiche (112, 212) aus auf dem Substrat befindlichem Halbleitermaterial voneinander getrennt sind, wobei die passiven Bereiche und die Streifenbereiche so angeordnet sind, daß zwischen benachbarten Streifenbereichen eine optische Streukopplung vorhanden ist.

2. Halbleiterlaser nach Anspruch 1, dadurch  g e k e n n - z e i c h n e t ,  daß jeder Streifenbereich eine erste Deckschicht aus auf dem Substrat befindlichem Halbleitermaterial aufweist, die einen niedrigeren Brechungsindex als die auf ihr angeordnete aktive Schicht besitzt, sowie eine zweite Deckschicht (108, 208) aus auf der aktiven Schicht angeordnetem Halbleitermaterial aufweist, die einen niedrigeren Brechungsindex als die aktive Schicht aufweist und daß  jeder passive Bereich (112, 212) einen höheren Brechungsindex als der effektive Brechungsindex der benachbarten Streifenbereiche aufweist.

3. Halbleiterlaser nach Anspruch 2, dadurch  g e k e n n - z e i c h n e t ,  daß mindestens einer der Streifenbereiche an einer seitlichen Grenze eine Zone (218, 220) aufweist, deren Brechungsindex höher als der effektive Brechungsindex
des Streifenbereichs, jedoch niedriger als der Brechungsindex
des angrenzenden passiven Bereichs (212) ist.

1/1

FIG 1

FIG 2

Europäisches
Patentamt

**EUROPÄISCHER RECHERCHENBERICHT**

**0045862**
Nummer der Anmeldung

EP 81 10 5620

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | FR - A - 2 348 589 (HITACHI) <br><br> * Seite 47, Zeilen 18-40; Seite 48, Zeilen 1-10; Figur 34 * <br><br> -- | 1 |
| A | APPLIED PHYSICS LETTERS, Band 33, Nr. 8, Oktober 1978 NEW YORK (US) D.R. SCIFRES et al.: "Beam scanning with twin-stripe injection lasers", Seiten 702-704. <br><br> * Seite 702, erster Absatz; Figur 1 * <br><br> -- | 1 |
| A | FR - A - 2 328 293 (R.T.C.) <br><br> * Patentansprüche 1-5; Figur 1 * <br><br> ----- | 1-3 |

**KLASSIFIKATION DER ANMELDUNG (Int. Cl 3)**

H 01 S 3/23

**RECHERCHIERTE SACHGEBIETE (Int. Cl.3)**

H 01 S   3/23 <br>          3/19 <br> H 01 L 27/15

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 24.11.1981 | ARMITANO GRIVEL |

EPA form 1503.1   06.78